Europäisches Patentamt

European Patent Office

Office européen des brevets

(11) Publication number: **0 039 177**
**B1**

(19)

(12) **EUROPEAN PATENT SPECIFICATION**

(45) Date of publication of patent specification: **25.01.84**

(51) Int. Cl.³: **H 04 N 3/15, H 01 L 27/14**

(21) Application number: **81301670.6**

(22) Date of filing: **15.04.81**

(54) **A solid-state imaging device.**

(30) Priority: **25.04.80 JP 54158/80**

(43) Date of publication of application:
**04.11.81 Bulletin 81/44**

(45) Publication of the grant of the patent:
**25.01.84 Bulletin 84/4**

(84) Designated Contracting States:
**DE FR GB NL**

(56) References cited:
**GB - A - 2 001 504**

(73) Proprietor: Hitachi, Ltd.
5-1, Marunouchi 1-chome
Chiyoda-ku Tokyo 100 (JP)

(72) Inventor: Aoki, Masakazu
1473-B5-1, Josuihoncho Kodaira-shi
Tokyo (JP)
Inventor: Ando, Haruhisa
2-32-A403, Koyasu-cho Hachioji-shi
Tokyo (JP)
Inventor: Ohba, Shinya
6-12-3, Higashi-koigakubo Kokubunji-shi
Tokyo (JP)
Inventor: Hanamura, Shoji
3-1-3, Higashi-koigakubo Kokubunji-shi
Tokyo (JP)
Inventor: Takemoto, Iwao
2196-458, Hirai Hinodemachi Nishitama-gun
Tokyo (JP)
Inventor: Izawa, Ryuichi
3-1-3, Higashi-Koigakubo Kokubunji-shi
Tokyo (JP)

(74) Representative: Ellis, Edward Lovell et al,
MEWBURN ELLIS & CO. 2/3 Cursitor Street
London EC4A 1BQ (GB)

A solid-state imaging device

The present invention relates to a solid-state imaging device, and more particularly to an enhancement in the dynamic range of the solid-state imaging device.

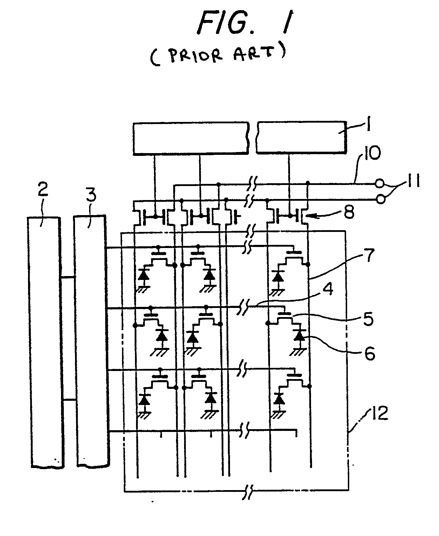

Figure 1 of the accompanying drawings shows a typical example of a known solid-state imaging device, see for example GB—A—2 001 504, (hereinafter referred to as a "photosensor"). It illustrates the fundamental circuit arrangement of a MOS-type photosensor in which picture elements employing insulated-gate field effect transistors (hereinafter referred to as "MOSTs") as vertical switching elements and employing the source junctions of the MOSTs as photodiodes which are arrayed in the form of a matrix. The solid-state imaging device shown in Figure 1, includes a shift register 1 which serves as a horizontal scanning circuit, a shift register 2 which serves as a vertical scanning circuit, an interlace circuit 3, a vertical scanning line 4 (vertical gate line) for addressing in the Y direction, a MOST 5 acting as a photogate which serves as a vertical switching element, a photodiode 6, a vertical signal output line 7, a horizontal switching element 8 for executing sequential addressing in the X direction with an output from the horizontal shift register 1, a horizontal signal output line 10, an output terminal 11, and a region 12 of a photodiode array.

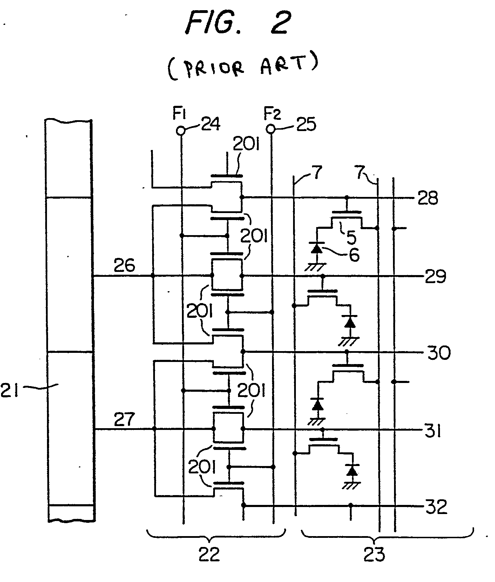

The interlace circuit 3 is shown in greater detail in Figure 2 of the accompanying drawings. The circuit shown includes the vertical shift register 21, the interlace circuit itself, here designated 22, and the region 23 of the photodiode array. The operation of the circuit illustrated in Figure 2 will now be described in greater detail. For example, in the case where a field pulse $F_1$ is applied to a terminal 24, the transmission of an output pulse from the vertical shift register 21 to an output line 26 results in that vertical gate lines 28 and 29 are simultaneously energized in response thereto. When an output pulse is subsequently transmitted to an output line 27, vertical gate lines 30 and 31 are simultaneously energized. On the other hand, in the case where a field pulse $F_2$ is applied to a terminal 25, pairs of vertical gate lines which are energized in response to the output pulses from the vertical shift register 21 to the output lines 26 and 27 are a set of the lines 29 and 30 and a set of lines 31 and 32, respectively. That is, the set of the vertical gate lines to be energized is shifted by the change-over of the field pulses, whereby the interlacing is achieved.

The photosensor of the known circuit arrangement as shown in Figures 1 and 2 has the disadvantage that there is a reduction in its dynamic range when the photosensor is miniaturized sufficiently to be manufactured on the mass-production basis with a sufficient number of picture elements to attain a resolution of a practical level. The packaging density of the photosensor as stated above exceeds the scale of a device being presently developed as a VLSI (Very Large Scale Integration), requires the fine patterning technology and results in inevitably the lowering of the supply voltage in relation to the device breakdown and reliability. This point is discussed in detail in, for example, H. Masuda et al., "Characteristics and Limitation of Scaled Down MOSFET's Due to Two-Dimensional Field Effect", IEEE Trans., Electron Devices, ED-26, 6, p. 980, June 1979.

In the photosensor of the circuit arrangement shown in Figures 1 and 2, interlace switches which are formed by MOSTs 201 are employed in the interlace circuit portion, and hence, voltage drops based on a threshold voltage $V_T$ are unavoidably caused. Even if a voltage kept intact at a supply voltage $V_{DD}$ is fed from the vertical shift register, only a voltage $(V_{DD}—V_T)$ will be applied to the vertical gate lines. In this case, the threshold voltage $V_T$ often has a large value on account of the substrate effect, and it is not uncommon that $(V_{DD}—V_T)$ is less than $V_{DD}$ by as much as 20 to 30%. Further, the dynamic range of the photosensor is given by $(V_{DD}—V_T—V_T')$ where $V_T'$ denotes the threshold voltage of the MOST 5. Therefore, the reduction of the dynamic range due to the threshold voltages is reduced to approximately only 50% of the supply voltage $V_{DD}$, which means that the dynamic range becomes much less than the supply voltage $V_{DD}$ which is low in itself as mentioned above. For example, in the case where the supply voltage $V_{DD}$ is 5 volts as used in a recent high-packaged MOSLSI, the dynamic range becomes less than approximately 1.5 volts on the supposition that $V_T \sim 2.0$ volts and $V_T' \sim 1.5$ volts ($V_T$ and $V_T'$ become large on account of the presence of the substrate effect). This is not practical for a high contrast scene, since the white level is greatly limited and thus causes the reproduced image to have a poor contrast.

It is an object of the present invention to overcome the above referred to disadvantages by improving the dynamic range of a photosensor.

According to the present invention there is provided a solid state imaging device including a plurality of photodiodes which are arrayed in two dimensions on an identical semiconductor body, a group of horizontal switching elements and a group of vertical switching elements which energize the photodiodes, a horizontal scanning circuit and a vertical scanning circuit which apply scanning pulses to the horizontal and vertical switching elements respectively, and having an interlaced scanning mechanism which energizes a plurality of vertical scanning lines by means of interlace switching elements so as to permit horizontal scanning of scanning lines of a plurality of rows; characterized in that said interlaced scanning mechanism includes means to recover a voltage level of the scanning pulse having undergone a voltage drop due to said interlace switching elements.

The present invention will now be described in greater detail by way of example with reference to the remaining figures of the accompanying drawings, wherein:—

Figure 3 is a block circuit diagram showing a preferred form of a solid-state imaging device;

Figure 4 is a schematic circuit diagram showing a preferred form of an interlace circuit as well as a vertical buffer circuit in the solid state imaging device shown in Figure 3; and

Figure 5 is a waveform diagram showing pulses at various nodes and the vertical buffer circuit-control pulses $\phi_{B1}$ and $\phi_{B2}$ which are shown in Figure 4.

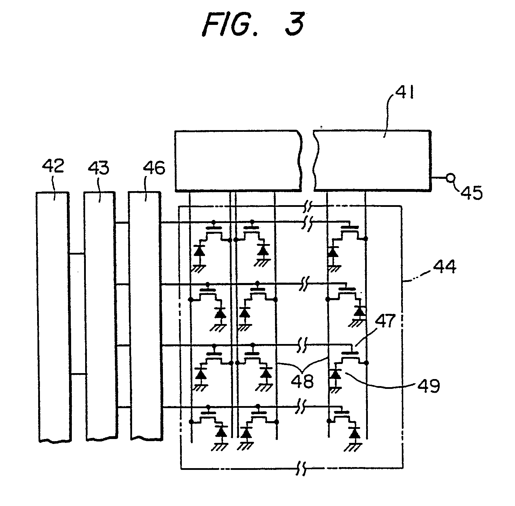

Referring first to Figure 3, the solid-state imaging device includes a block 41 into which a horizontal shift register and horizontal switching elements are combined, a vertical shift register 42, an interlace circuit 43, a photodiode array 44, an output terminal 45 (a plurality of output terminals may well be used in an alternative form), a vertical buffer circuit 46, MOSTs 47 acting as photogates, vertical signal output lines 48, and photodiodes 49.

The vertical buffer circuit 46 raises an output pulse from the vertical register 42 having undergone a voltage drop by passing through the interlace circuit 43, up to a predetermined high level of a driving pulse for a vertical gate line again and recovers it enough to apply the highest voltage ($V_{DD}$) to the MOST 47. Thus, a photosensor of wide dynamic range is obtained.

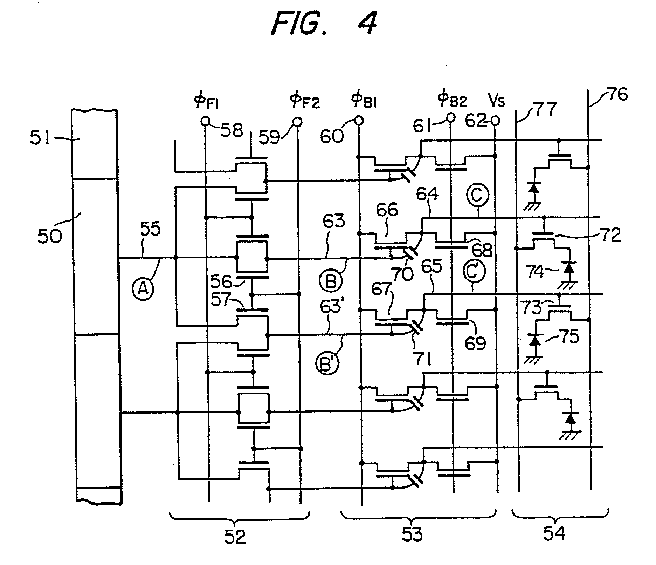

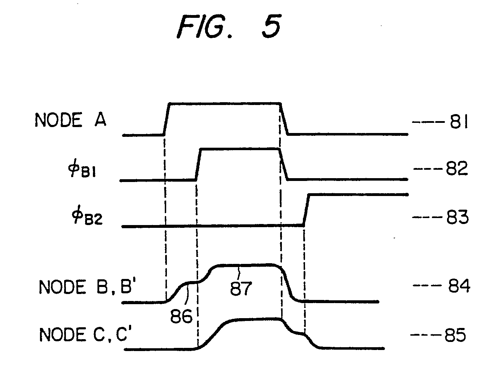

Referring now to Figure 4 the vertical buffer circuit shown in Figure 3 includes a unit circuit 51 which constitutes one stage of the vertical shift register, here designated 50, the interlace circuit, here designated 52, the vertical buffer circuit, here designated 53, and a photodiode array 54. The operation of the circuit shown in Figure 4 will now be described in greater detail with reference also to the waveforms shown in Figure 5.

Let us suppose that in the arrangement of Figure 4, the output pulse (voltage $V_{DD}$) from the vertical shift register 50 is applied on a node A of an output line 55 as shown at 81 in Figure 5. Field pulses $\phi_{F1}$ and $\phi_{F2}$ are respectively applied to terminals 58 and 59, and the latter pulse $\phi_{F2}$ is assumed to be at a high level ($V_{DD}$) and the former pulse $\phi_{F1}$ to be at a low level (in the converse case, the following situation holds similarly). At nodes B and B' of output lines 63 and 63', voltages ($V_{DD}$—$V_T$) appear as shown at 86 in a waveform 84 of Figure 5 ($V_T$ indicates the magnitude of the threshold voltages of MOSTs 56 and 57). Subsequently, a pulse $\phi_{B1}$ is applied to a terminal 60 during a period shown by waveform 82 in Figure 5. Then, as shown at 87 in Figure 5, the voltages of the nodes B and B' become substantially higher than the voltage $V_{DD}$ owing to the bootstrap effect through the capacitances (parasitic capacitances or additional capacitances) 70 and 71 between the gates and the sources of respective buffer MOSTs 66 and 67. In consequence, at nodes C and C' of vertical scanning lines (vertical gate lines) 64 and 65 connected to MOSTs 72 and 73 respectively acting as photogates, the high level $V_{DD}$ of the pulse $\phi_{B1}$ is applied as shown by waveform 85 in Figure 5. In this way, sufficiently high voltages $V_{DD}$ free from the threshold voltage drops are applied to the MOSTs 72 and 73, so that the dynamic range of the photosensor is ensured.

A pulse $\phi_{B2}$ is applied to a terminal 61 during a period as shown by waveform 83 in Figure 5, whereby the voltages of the vertical gate lines 64 and 65 leading to the respective MOSTs 72 and 73 acting as photogates are lowered again. Owing to this method, even when the voltage of the low level of the pulse $\phi_{B1}$ is somewhat above zero volts, the voltages of the vertical gate lines leading to the photogates can be exactly brought down to a voltage $V_S$ (for example, zero volts) of a terminal 62. When the pulse $\phi_{B2}$ is kept at the high level during one horizontal scanning period, the photogate can be held at a low impedance, and a state immune to interfering noise can be established. The former is especially effective for preventing carriers from flowing as a tailing current underneath the photogate due to the overflow of the photodiode.

By repeating the cycles as stated above, signals of the picture elements are read out in succession.

The solid-state imaging device as described above, is applicable to any photosensor insofar as it is of the X—Y addressing type and it includes an interlace circuit and a vertical scanning circuit consisting of MOSTs. For example, the horizontal scanning circuit of the block 41 in Figure 3 is not restricted to a digital shift register which consists of MOSTs, but it may equally well consist of charge transfer devices (hereinafter referred to as "CTDs") which handle analog signals. In this case, the block 41 becomes a circuit which includes the CTDs and switching elements for transmitting signals from the vertical signal output lines 48 to the CTDs.

In Figure 3, the MOS type photosensor having the array 44 of the p-n junction diodes has been shown. However, this is not restrictive, but CIDs (Charge Injection Devices; also of the X—Y addressing type) may equally well be used.

The positions of the horizontal and vertical registers, shown in Figure 3 are not restricted to the upper and left hand parts. For example, the vertical circuits may well be arranged on the right hand side. The horizontal register may well be arranged on the lower side, or divided into upper and lower portions which are alternately used.

In the above described embodiment the case where electrons are signal carriers (n-channel) is utilized. However, this is not restrictive, and the circuits are equally applicable to the case where holes are utilized as the signal carriers (p-channel) by, for example, inverting the polarities of the pulses and the conductivity types of the regions of the MOSTs and the diodes.

As described above, the buffer circuit is arranged between the interlace circuit and the vertical gate lines of a photosensor, in order to realize a photosensor which can apply to the photogates sufficiently high pulses free from threshold voltage drops, in order to produce a wide dynamic range and which undergoes no degradation of the reproduced image even in the case of a scene having a high contrast.

## Claims

1. A solid-state imaging device including a plurality of photodiodes (49, 74, 75) which are arrayed in two dimensions on an identical semiconductor body, a group of horizontal switching elements (8) and a group of vertical switching elements (47) which energize the photodiodes, a horizontal scanning circuit (41) and a vertical scanning circuit (42) which apply scanning pulses to the horizontal and vertical switching elements respectively, and having an interlaced scanning mechanism (43) which energizes a plurality of vertical scanning lines (48) by means of interlace switching elements (56, 57) so as to permit horizontal scanning of scanning lines of a plurality of rows; characterized in that said interlaced scanning mechanism includes means (46, 53) to recover a voltage level of the scanning pulse having undergone a voltage drop due to said interlace switching elements.

2. A solid-state imaging device according to Claim 1, characterized in that said interlaced scanning mechanism includes an interlace circuit (52) which changes-over a combination of the vertical scanning lines to be energized by means of interlace switching elements (56, 57) every field, and a vertical buffer circuit (53) which recovers the voltage level of the scanning pulse having passed through said interlace circuit (52).

3. A solid-state imaging device according to Claim 2, characterized in that said vertical buffer circuit (53) includes insulated-gate field effect transistors (66, 67) for recovering voltage drops which are arranged at the respective vertical scanning lines, which receive output signals from said interlace circuit (52) as their gate inputs and which are driven by driving pulses synchronous with output pulses of said vertical scanning circuit, and capacitances (70, 71) which contribute to the bootstrap effect existing between the gates and sources of said insulated-gate field effect transistors (66, 67) for recovering voltage drops.

4. A solid-state imaging device according to Claim 2, characterized in that said interlace circuit (52) includes first to fourth switching elements which consist of insulated-gate field effect transistors (56, 57) connected at the outputs of respective stages of unit circuits (51) constituting said vertical scanning circuit (50) and which permit the simultaneous horizontal scanning of the scanning lines of two rows, first and second field pulses being respectively applied to a set of said first and second switching elements and a set of said third and fourth switching elements, said first and second switching elements being operated in a first field and said third and fourth switching elements in a second field by the use of output pulses provided from said vertical scanning circuit in timed sequence with said field pulses, in order to generate gate input pulses to said insulated-gate field effect transistors so as to recover the voltage drops.

5. A solid-state imaging device according to Claim 4, characterized in that the sources (or drains) of the first to fourth switching elements are connected to the outputs of the respective stages of said unit circuits (51) constituting said vertical scanning circuit (50); the drain (or source) of said first switching element (57), the drains (or sources) of said second and third switching elements (56) and the drain (or source) of said fourth switching element (57) are respectively connected to the gates of the insulated-gate field effect transistors (66 and 67) for recovering the voltage drops, of the vertical scanning lines of a first row, second row and third row corresponding to the stages of said unit circuits; the field pulses being applied to the gates of said first to fourth switching elements; the drains (or sources) of said insulated-gate field effect transistors (66, 67) for recovering the voltage drops being connected to a first common line (60), on which driving pulses ($\phi_{B1}$) synchronous with output pulses provided from said vertical scanning circuit in timed sequence are applied; and the sources (or drains) of said insulated-gate field effect transistors (66, 67) for recovering the voltage drops being connected to the respective vertical scanning lines (64, 65).

6. A solid-state imaging device according to Claim 5, characterized in that the drains (or sources) of further insulated-gate field effect transistors (68) for resetting, whose gates are connected to a second common line (61) and whose sources (or drains) are connected to a third common line (62), are connected to the sources (or drains) of said insulated-gate field effect transistors (66, 67) for recovering the voltage drops, a reset pulse ($\phi_{B2}$) being applied to said second common line (61) and said third common line (62) being earthed or held at zero volts.

7. A solid-state imaging device according to any one of the preceding Claims 2 to 6, characterized in that said vertical and horizontal switching elements are constructed of insulated-gate field effect transistors, and source junctions of said vertical switching elements (72, 73) are employed as said photodiodes (74, 75).

## Patentansprüche

1. Festkörper-Bildaufnahmevorrichtung mit einer Vielzahl von Photodioden (49, 74, 75), die in zwei Dimensionen auf ein und demselben Halbleiterkörper angeordnet sind, einer Gruppe von Horizontal-Schaltelementen (8) und einer Gruppe von die Photodioden beaufschlagenden Vertikal-Schaltelementen (47), einer Horizontal-Taststufe (41) und einer Vertikal-Taststufe (42) zum Anlegen von Tastimpulsen an die Horizontal- bzw. Vertikal-Schaltelemente, sowie mit einem Verflecht-Tastmechanismus (43), der eine Vielzahl von Vertikal-Tastleitungen (48) mittels Verflecht-Schaltelementen (56, 57) derart beaufschlagt, daß eine Horizontal-Tastung von Tastleitungen einer Vielzahl von Zeilen ermöglicht wird; dadurch gekennzeichnet, daß der Verflecht-Tastmechanismus eine Einrichtung (46, 53) umfaßt, um einen Spannungspegel des Tastimpulses wiederzugewinnen, der einem Spannungsabfall aufgrund der Verflecht-Schaltelemente unterworfen war.

2. Festkörper-Bildaufnahmevorrichtung nach Anspruch 1, dadurch gekennzeichnet, daß der Verflecht-Tastmechanismus eine Verflechtungsstufe (52), die die Kombination der zu beaufschlagenden Vertikal-Tastleitungen mittels der Verflecht-Schaltelemente (56, 57) in jedem Halbbild umschaltet, sowie eine Vertikal-Pufferstufe (53) umfaßt, die den Spannungspegel des durch die Verflechtungsstufe (52) hindurchgelaufenen Tastimpulses wieder herstellt.

3. Festkörper-Bildaufnahmevorrichtung nach Anspruch 2, dadurch gekennzeichnet, daß die Vertikal-Pufferstufe (53) zur Wiedergewinnung von Spannungsabfällen Isolierschicht-Feldeffekttransistoren (66, 67), die an den jeweiligen Vertikal-Tastleitungen angeordnet sind, als Gate-Eingangssignale Ausgangssignale der Verflechtungsstufe (52) empfangen und durch mit den Ausgangsimpulsen der Vertikal-Taststufe synchrone Treiberimpulse angesteuert sind, sowie Kondensatoren (70, 71) umfaßt, die den zwischen den Gate- und Source-Elektroden der Isolierschicht-Feldeffekttransistoren (66, 67) vorhandenen Bootstrap-Effekt zur Wiedergewinnung von Spannungsabfällen unterstützen.

4. Festkörper-Bildaufnahmevorrichtung nach Anspruch 2, dadurch gekennzeichnet, daß die Verflechtungsstufe (52) erste bis vierte Schaltelemente umfaßt, die aus Isolierschicht-Feldeffekttransistoren (56, 57) bestehen, welche an die Ausgänge jeweiliger, die Vertikal-Taststufe (50) bildender Stufen von Einheitskreisen (51) angeschlossen sind, und die die gleichzeitige horizontale Tastung der Tastleitungen zweier Zeilen gestatten, wobei an einer Gruppe der ersten und zweiten Schaltelemente ein erster Halbbildimpuls und an einer Gruppe der dritten und vierten Schaltelementen ein zweiter Halbbildimpuls liegt, und wobei unter Verwendung von Ausgangsimpulsen, die die Vertikal-Taststufe in zeitlich gesteuerter Folge mit den Halbbildimpulsen liefert, um die Gate-Eingangspulse der Isolierschicht-Feldeffekttransistoren zur Wiedergewinnung der Spannungsabfälle zu erzeugen, das erste und das zweite Schaltelement in einem ersten Halbbild sowie das dritte und das vierte Schaltelement in einem zweiten Halbbild betrieben werden.

5. Festkörper-Bildaufnahmevorrichtung nach Anspruch 4, dadurch gekennzeichnet, daß die Source- (oder Drain-)Elektroden der ersten bis vierten Schaltelemente an die Ausgänge der jeweiligen Stufen der die Vertikal-Taststufe (50) bildenden Einheitskreise angeschlossen sind; daß die Drain- (oder Source-)Elektrode des ersten Schaltelements (57), die Drain- (oder Source-)Elektroden des zweiten und des dritten Schaltelements (56) und die Drain- (oder Source-)Elektrode des vierten Schaltelements (57) mit den jeweiligen Gate-Elektroden der Isolierschicht-Feldeffekttransistoren (66 und 67) zur Wiedergewinnung der Spannungsabfälle der Vertikal-Tastleitungen einer ersten, einer zweiten und einer dritten Zeile entsprechend den Stufen der Einheitskreise verbunden sind; daß die Halbbildimpulse an den Gate-Elektroden der ersten bis vierten Schaltelemente liegen; daß die Drain- (oder Source-(Elektroden der Isolierschicht-Feldeffekttransistoren (66, 67) zur Wiedergewinnung der Spannungsabfälle mit einer ersten gemeinsamen Leitung (60) verbunden sind, an der Treiberimpulse ($\phi_{B1}$) liegen, die mit von der Vertikal-Taststufe in zeitlich gesteuerter Folge bereit gestellten Ausgangsimpulsen synchron sind; und daß die Source- (oder Drain-)Elektroden der Isolierschicht-Feldeffekttransistoren (66, 67) zur Wiedergewinnung der Spannungsabfälle an die jeweiligen Vertikal-Tastleitungen (64, 65) angeschlossen sind.

6. Festkörper-Bildaufnahmevorrichtung nach Anspruch 5, dadurch gekennzeichnet, daß die Drain- (oder Source-)Elektroden weiterer Isolierschicht-Feldeffekttransistoren (68) zur Rückstellung, deren Gate-Elektroden an eine zweite gemeinsame Leitung (61) und deren Source- (oder Drain-)Elektroden an eine dritte gemeinsame Leitung (62) angeschlossen sind, mit den Source- (oder Drain-)Elektroden der Isolierschicht-Feldeffekttransistoren (66, 67) zur Wiedergewinnung der Spannungsabfälle verbunden sind, wobei an der zweiten gemeinsamen Leitung (61) ein Rückstellimpuls ($\phi_{B2}$) liegt und die dritte gemeinsame Leitung (62) geerdet oder auf null Volt gehalten ist.

7. Festkörper-Bildaufnahmevorrichtung nach einem der Ansprüche 2 bis 6, dadurch gekennzeichnet, daß die Vertikal- und die Horizontal-Schaltelemente aus Isolierschicht-Feldeffekttransistoren aufgebaut sind und die Source-Übergänge der Vertikal-Schaltelemente (72, 73) als die Photodioden (74, 75) verwendet werden.

**Revendications**

1. Dispositif de formation d'images à l'état solide comportant une pluralité de photodiodes (49; 74, 75) qui sont disposées suivant un réseau bidimensional sur un corps semiconducteur identique, un groupe d'éléments de commutation horizontale (8) et un groupe d'élément de commutation verticale (47), qui excitent les photodiodes, un circuit de balayage horizontal (41) et un circuit de balayage vertical (42), qui appliquent des impulsions de balayage respectivement aux éléments de commutation horizontale et verticale, et comportant un mécanisme de balayage entrelacé (43) qui excite une pluralité de lignes de balayage.vertical (48) au moyen d'éléments de commutation avec entrelacement (56, 57) de manière à permettre un balayage horizontal de lignes de balayage d'une pluralité de rangées, caractérisé en ce que ledit mécanisme de balayage entrelacé comporte des moyens (46, 53) permettant de récupérer un niveau de tension de l'impulsion de balayage ayant été soumise à une chute de tension provoquée par lesdits éléments de commutation avec entrelacement.

2. Dispositif de formation d'images à l'état solide selon la revendication 1, caractérisé en ce que ledit mécanisme de balayage entrelacé comporte un circuit d'entrelacement (52), qui modifie une combinaison des lignes de balayage vertical devant être excitées au moyen des éléments de commutation avec entrelacement (56, 57) lors de chaque image, et un circuit tampon vertical (53) qui récupère le niveau de tension de l'impulsion de balayage qui a traversé ledit circuit d'entrelacement (52).

3. Dispositif de formation d'images à l'état solide selon la revendication 2, caractérisé en ce que ledit circuit tampon vertical (53) comporte des transistors à effet de champ à grille isolée (66, 67) permettant de récupérer des chutes de tension et qui sont disposés dans les lignes respectives de balayage vertical, reçoivent des signaux de sortie provenant dudit circuit d'entrelacement (52) en tant que signaux d'entrées sur leurs grilles et qui sont commandés par des impulsions de commande synchrones avec des impulsions de sortie dudit circuit de balayage vertical, et des capacités (70, 71) qui contribuent à réaliser l'effet d'auto-élévation existant entre les grilles et les sources desdits transistors à effet de champ à grille isolé (66, 67) pour réaliser la récupération des chutes de tension.

4. Dispositif de formation d'images à l'état solide selon la revendication 2, caractérisé en ce que ledit circuit d'entrelacement (52) comprend un premier, un second, un troisième et un quatrième élémente de commutation qui sont constitués par des transistors à effet de champ à grille isolée (56, 57) raccordés aux sortie d'étages respectifs de circuits unités (51), constituant ledit circuit de balayage vertical (50), et qui permettent le balayage horizontal simultané des lignes de balayage de deux rangées, que des première et seconde impulsions de champ sont appliquées respectivement à un ensemble formé desdits premier et second éléments de commutation et à un ensemble desdits troisième et quatrième éléments de commutation, lesdits premier et second éléments de commutation étant actionnés pendant une première image et lesdits second et troisième éléments de commutation étant actionnés pendant une seconde image moyennant l'utilisation des impulsions de sortie délivrées par le circuit de balayage vertical selon une séquence synchronisée avec lesdites impulsions de champ, de manière à délivrer des impulsions d'entrée de grille auxdits transistors à effet de champ à grille isolée de manière à récupérer les chutes de tension.

5. Dispositif de formation d'images à l'état solide selon la revendication 4, caractérisé en ce que les sources (ou drains) des premier, second, troisième et quatrième éléments de commutation sont raccordés aux étages respectifs desdits circuits unités (51) constituant ledit circuit de balayage vertical (50), que le drain (ou la source) dudit premier élément de commutation (57), les drains (ou les sources) desdits second et dudit troisième éléments de commutation (56) et le drain (ou la source) dudit quatrième élément de commutation (57) sont raccordés respectivement aux grilles des transistors à effet de champ à grille isolée (66 et 67) servant à la récupération des chutes de tension, des lignes de balayage vertical d'une première rangée, d'une seconde rangée et d'une troisième rangée correspondant aux étages desdits circuits unités, les impulsions de champ étant appliquées aux grilles desdits premier, second, troisième et quatrième éléments de commutation, les drains (ou des sources) desdits transistors à effet de champ à grille isolée (66, 67) servant à la récupération des chutes de tension et étant raccordés à une première ligne commune (60) dans laquelle sont transmises, selon une séquence synchronisée, des impulsions de commande ($\phi_{B1}$) en synchronisme avec des impulsions de sortie délivrées par ledit circuit de balayage vertical, tandis que les sources (ou drains) desdits transistors à effet de champ à grille isolée (66; 67) servant à la récupération des chutes de tension sont raccordées aux lignes respectives de balayage vertical (64, 65).

6. Dispositif de formation d'images à l'état solide selon la revendication 5, caractérisé en ce que les drains (our les sources) d'autres transistors à effet de champ à grille isolée (68) servant à la remise à l'état initial et dont les grilles sont raccordées à une seconde ligne commune (61) et dont les sources (ou les drains) sont raccordées à une troisième ligne commune (63), sont raccordés aux sources (ou aux drains) desdits transistors à effet de champ à grille isolée (66, 67) servant à la récupération des chutes de tension, une impulsion de remise à l'état initial ($\phi_{B2}$) étant appliquée à ladite seconde ligne commune (61), tandis que ladite troisième ligne commune (62) est mise à la terre ou maintenue à zéro volt.

7. Dispositif de formation d'images à l'état solide selon l'une quelconque des revendications précédentes 2 à 6, caractérisé en ce que lesdits éléments de commutation verticale et horizontale sont constitués par des transistors à effet de champ à grille isolée et que les jonctions des sources desdits éléments de commutation verticale (71, 72) sont utilisées pour constituer lesdites photodiodes (74, 75).

FIG. I

(PRIOR ART)

0 039 177

1

# FIG. 2

(PRIOR ART)

2

# FIG. 3

# FIG. 4

# FIG. 5